# EUROPEAN PATENT APPLICATION

(11) **EP 1 006 591 A2**
(43) Date of publication of application: **07.06.2000**
(21) Application number: 99123214.1
(22) Date of filing: 25.11.1999
(51) Int. Cl.: H01L 31/02, H01L 31/107, H03F 3/08, H03F 1/30, H04B 10/04

(54) **Circuit, method and record medium for applying DC bias voltage to avalanche photodiode**

(30) Priority: 03.12.1998 JP 34463398
(71) Applicant: NEC CORPORATION, Tokyo (JP)
(72) Inventor: Sunil, Priyadarshi, Minato-ku, Tokyo (JP)
(74) Representative: VOSSIUS & PARTNER

(57) **Abstract**

An APD biasing circuit, for applying a bias voltage (Vj) to an APD (Avalanche PhotoDiode) (1) which outputs a photo detection signal corresponding to the intensity of a photo signal supplied thereto, comprises a temperature detector (5a) such as a thermistor, a ROM (5c), a D/A converter (5d), a power supply (4) and a transistor (3). The temperature detector (5a) detects the temperature around the APD (1). The ROM (5c) preliminarily stores voltage data corresponding to a plurality of temperatures in a prescribed temperature range. The voltage data are preliminarily set so as to properly control the bias voltage (Vj) of the APD (1) and thereby compensate for the temperature-variation of the gain of the APD (1). The ROM (5c) outputs voltage data corresponding to the temperature which has been detected by the temperature detector (5a) to the D/A converter (5d). The D/A converter (5d) converts the voltage data into an analog voltage. The transistor (3), whose collector is supplied with a constant power source voltage (Vcc) from the power supply (4), amplifies the power source voltage (Vcc) depending on the analog voltage which is supplied from the D/A converter (5d) to its base, and outputs the amplified voltage from its emitter to the cathode of the APD (1) via a resistor (R), thereby the temperature-variation of the gain of the APD (1) is compensated and eliminated in a wide temperature range.

## Description

The present invention relates to a circuit and a method for applying DC voltage to an APD (Avalanche PhotoDiode). Description of the Prior Art

Avalanche photodiodes (APDs) are widely used for photo detectors. The gain of an APD is given as a function of the reverse-bias voltage and the temperature. Therefore, the S/N (signal-to-noise ratio) of a photo detection signal outputted by the APD has to be kept constant by compensating for the temperature-variation of the gain of the APD by controlling the bias voltage appropriately.

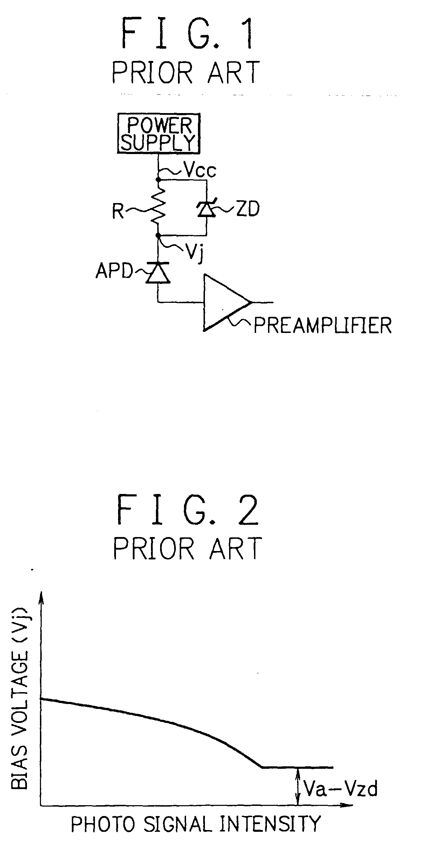

Fig.1 is a circuit diagram showing an example of a conventional APD biasing circuit. When the intensity of an input photo signal increases, current which passes the resistor R increases and thereby voltage drop of the resistor R increases. A Zener diode ZD is connected in parallel with the resistor R. As the current and the voltage drop increases, the bias voltage Vj of the APD keeps on decreasing until the voltage drop reaches the clamp voltage Vzd of the Zener diode ZD, that is, the bias voltage Vj keeps on decreasing until it reaches Vcc - Vzd, as shown in Fig.2. In the conventional APD biasing circuit of Fig.1, the minimum bias voltage of the APD is ensured by use of the Zenner diode ZD as shown in Fig.2, and thereby malfunction of the APD due to incidence of high level photo signals is prevented. However, compensation for the temperature-variation of the gain of the APD is not executed by the conventional APD biasing circuit, and thus the bias voltage Vj can not be maintained optimally so as to maintain the gain of the APD constant in a wide temperature range.

It is therefore the primary object of the present invention to provide an APD biasing circuit and an APD biasing method by which the bias voltage Vj of an APD can be controlled optimally so that the gain of the APD will be maintained constant in a wide temperature range.

In accordance with a first aspect of the present invention, there is provided an APD biasing circuit for applying a bias voltage to an APD (Avalanche PhotoDiode) which outputs a photo detection signal corresponding to the intensity of a photo signal supplied thereto, comprising a temperature detector means, a storage means, a D/A converter means, and a voltage control means. The temperature detector means detects the temperature around the APD. The storage means preliminarily stores voltage data corresponding to a plurality of temperatures in a prescribed temperature range. The voltage data are data which have been set so as to properly control the bias voltage of the APD and thereby compensate for the temperature-variation of the gain of the APD. The storage means outputs voltage data corresponding to the temperature which has been detected by the temperature detector means. The D/A converter means converts the voltage data which has been outputted by the storage means into an analog voltage. The voltage control means controls the bias voltage of the APD based on the analog voltage.

In accordance with a second aspect of the present invention, in the first aspect, the APD biasing circuit further comprises an A/D converter for converting an analog temperature detection signal outputted by the temperature detector means into a digital signal to be supplied to the storage means.

In accordance with a third aspect of the present invention, in the first aspect, the voltage control means includes a resistor, a power supply and a transistor. The resistor is connected in series with the APD so as to reduce the bias voltage by its voltage drop as the photo signal intensity increases. The power supply outputs a constant power supply voltage. The collector of the transistor is supplied with the power supply voltage from the power supply. The base of the transistor is supplied with the analog voltage from the D/A converter means. The emitter of the transistor is connected to the APD via the resistor.

In accordance with a fourth aspect of the present invention, in the third aspect, the voltage control means further includes a Zenner diode which is connected in parallel with the resistor so as to ensure the minimum bias voltage of the APD.

In accordance with a fifth aspect of the present invention, in the first aspect, the voltage control means includes a power supply and a transistor. The power supply outputs a constant power supply voltage. The collector of the transistor is supplied with the power supply voltage from the power supply. The base of the transistor is supplied with the analog voltage from the D/A converter means. The emitter of the transistor is connected to the APD.

In accordance with a sixth aspect of the present invention, in the first aspect, the D/A converter means and the voltage control means are implemented by a D/A converter whose analog output voltage is supplied to the APD via a resistor which reduces the bias voltage by its voltage drop as the photo signal intensity increases.

In accordance with a seventh aspect of the present invention, in the sixth aspect, the voltage control means further includes a Zenner diode which is connected in parallel with the resistor so as to ensure the minimum bias voltage of the APD.

In accordance with an eighth aspect of the present invention, in the first aspect, the D/A converter means and the voltage control means are implemented by a D/A converter whose analog output voltage is supplied to the APD.

In accordance with a ninth aspect of the present invention, in the first aspect, the storage means is implemented by an EPROM (Erasable Programmable Read Only Memory).

In accordance with a tenth aspect of the present invention, in the first aspect, the APD biasing circuit further comprises a voltage data setting/writing controller means for executing voltage data setting/writing process for the storage means. In a voltage data setting process, the voltage data writing controller means outputs voltage data to the D/A converter means in place of the storage means gradually changing the voltage data so that suitable voltage data capable of making the bit error rate of the photo detection signal lower than a prescribed error rate will be found for temperatures in a prescribed temperature range. In a voltage data writing process, the voltage data writing controller means writes the suitable voltage data for the temperatures in the prescribed temperature range which have been found in the voltage data setting process into the storage means.

In accordance with an eleventh aspect of the present invention, there is provided an APD biasing method for applying a visa voltage to an APD (Avalanche PhotoDiode) which outputs a photo detection signal corresponding to the intensity of a photo signal supplied thereto. The method comprises a temperature detection step, a voltage data readout step, a D/A conversion step, and a voltage control step. In the temperature detection step, the temperature around the APD is detected by a temperature detector means. In the voltage data readout step, voltage data corresponding to the temperature which has been detected in the temperature detection step is read out from a corresponding temperature address of a storage means. The storage means preliminarily stores voltage data corresponding to a plurality of temperatures in a prescribed temperature range. The voltage data are data which have been set so as to properly control the bias voltage of the APD and thereby compensate for the temperature-variation of the gain of the APD. In the D/A conversion step, the voltage data which has been read out in the voltage data readout step is converted by a D/A converter means into an analog voltage. In the voltage control step, the visa voltage of the APD is controlled based on the analog voltage which has been obtained in the D/A conversion step.

In accordance with a twelfth aspect of the present invention, in the eleventh aspect, the APD biasing method further comprises an A/D conversion step in which an analog temperature detection signal outputted by the temperature detector means is converted into a digital signal to be used by the storage means in the voltage data readout step.

In accordance with a thirteenth aspect of the present invention, in the eleventh aspect, the voltage control step is executed by a resistor, a power supply and a transistor. The resistor is connected in series with the APD so as to reduce the bias voltage by its voltage drop as the photo signal intensity increases. The power supply outputs a constant power supply voltage. The collector of the transistor is supplied with the power supply voltage from the power supply. The base of the transistor is supplied with the analog voltage from the D/A converter means. The emitter of the transistor is connected to the APD via the resistor.

In accordance with a fourteenth aspect of the present invention, in the thirteenth aspect, the voltage control step includes a clamping step in which a Zenner diode which is connected in parallel with the resistor clamps the voltage drop of the resistor when the voltage drop became as large as its clamp voltage, and thereby ensures the minimum visa voltage of the APD.

In accordance with a fifteenth aspect of the present invention, in the eleventh aspect, the voltage control step is executed by a power supply and a transistor. The power supply outputs a constant power supply voltage. The collector of the transistor is supplied with the power supply voltage from the power supply. The base of the transistor is supplied with the analog voltage from the D/A converter means. The emitter of the transistor is connected to the APD.

In accordance with a sixteenth aspect of the present invention, in the eleventh aspect, the D/A conversion step and the voltage control step are executed by a D/A converter whose analog output voltage is supplied to the APD via a resistor which reduces the bias voltage by its voltage drop as the photo signal intensity increases.

In accordance with a seventeenth aspect of the present invention, in the sixteenth aspect, the voltage control step includes a clamping step in which a Zenner diode which is connected in parallel with the resistor clamps the voltage drop of the resistor when the voltage drop became as large as its clamp voltage, and thereby ensures the minimum visa voltage of the APD.

In accordance with an eighteenth aspect of the present invention, in the eleventh aspect, the D/A conversion step and the voltage control step are executed by a D/A converter whose analog output voltage is supplied to the APD.

In accordance with a nineteenth aspect of the present invention, there is provided a computer-readable record medium storing a program for instructing a computer or a DSP (Digital Signal Processor) to execute processes for controlling a visa voltage which is applied to an APD (Avalanche PhotoDiode) which outputs a photo detection signal corresponding to the intensity of a photo signal supplied thereto. The processes include a temperature detection signal reception step, a voltage data readout step, and a voltage data output step. In the temperature detection signal reception step, a temperature detection signal representing the temperature around the APD which has been detected by a temperature detector means is received. In the voltage data readout step, voltage data corresponding to the temperature represented by the temperature detection signal is read out from a corresponding temperature address of a storage means. The storage means preliminarily stores voltage data corresponding to a plurality of temperatures in a prescribed temperature range. The voltage data are data which have been set so as to properly control the bias voltage of the APD and thereby compensate for the temperature-variation of the gain of the APD. In the voltage data output step, the voltage data which has been read out from the storage means in the voltage data readout step is outputted so as to be converted into an analog voltage and thereafter used for controlling the visa voltage of the APD.

In accordance with a twentieth aspect of the present invention, in the nineteenth aspect, the processes further include an A/D conversion step in which an analog temperature detection signal outputted by the temperature detector means is converted into a digital signal to be used by the storage means in the voltage data readout step.

The objects and features of the present invention will become more apparent from the consideration of the following detailed description taken in conjunction with the accompanying drawings, in which:
Fig.1 is a circuit diagram showing an example of a conventional APD biasing circuit;
Fig.2 is a graph showing the characteristics of a bias voltage Vj which is controlled by the conventional APD biasing circuit of Fig.1;
Fig.3 is a circuit diagram showing an APD biasing circuit in accordance with a first embodiment of the present invention;
Fig.4 is a circuit diagram showing an APD biasing circuit in accordance with a second embodiment of the present invention;
Fig.5 is a flow chart showing an example of a procedure for setting and writing voltage data corresponding to each temperature in a ROM of the APD biasing circuit of Fig.4;
Fig.6 is a graph showing a result of a simulation with regard to the bias voltage Vj according to the second embodiment of the present invention;
Figs.7 and 8 are circuit diagrams showing other examples of APD biasing circuits in accordance with the present invention, in which transistors and power supplies employed in Figs.3 and 4 are not employed; and
Figs.9 and 10 are circuit diagrams showing other examples of APD biasing circuits in accordance with the present invention, in which resistors employed in Figs.3 and 7 are not employed.

Referring now to the drawings, a description will be given in detail of preferred embodiments in accordance with the present invention.

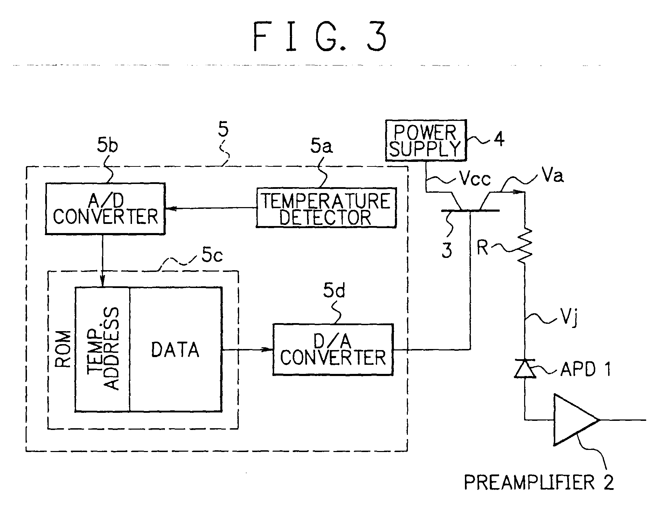

Fig.3 is a circuit diagram showing an APD biasing circuit in accordance with a first embodiment of the present invention. Referring to Fig.3, the anode of an avalanche photodiode (APD) 1 is connected to the input terminal of a preamplifier 2, and the cathode of the APD 1 is connected to the emitter of a transistor 3 via a resistor R. The collector of the transistor 3 is connected to the power supply 4, and thereby a constant power supply voltage Vcc is applied to the collector. The base of the transistor 3 is connected to the output terminal of a digital temperature compensation circuit 5.

Therefore, the APD 1 is reversely biased by the emitter voltage Va of the transistor 3 via the resistor R. A photo detection signal due to incidence of a photo signal is outputted by the APD 1 from its anode to the preamplifier 2. The emitter voltage Va of the transistor 3 is controlled by the base voltage, that is, a voltage which is applied by the digital temperature compensation circuit 5 to the base of the transistor 3.

The digital temperature compensation circuit 5 includes a temperature detector 5a, an A/D converter 5b, a ROM (Read Only Memory) 5c, and a D/A converter 5d. The temperature detector 5a is implemented by, for example, a thermistor. An EPROM (Erasable Programmable Read Only Memory) can be used, for example, as the ROM 5c. While the A/D converter 5b and the temperature detector 5a which outputs analog signals are employed in the digital temperature compensation circuit 5 shown in Fig.3, it is also possible to employ a temperature detector 5a which outputs digital signals. In such cases, the A/D converter 5b is unnecessary.

The temperature around the APD 1 is detected by the temperature detector 5a and an analog temperature detection signal is supplied to the A/D converter 5b. The A/D converter 5b converts the analog temperature detection signal into a digital signal and supplies the digital signal to the ROM 5c. The digital signal is used for designating an address (temperature address) of the ROM 5c. When a digital signal designating a temperature address is supplied to the ROM 5c, voltage data which has been stored in the temperature address of the ROM 5c is read out and supplied to the D/A converter 5d. The D/A converter 5d converts the digital voltage data into an analog voltage and supplies the voltage to the base of the transistor 3.

In the APD biasing circuit of Fig.3, the control of the emitter voltage Va of the transistor 3 depending on the temperature detected by the temperature detector 5a can arbitrarily be executed, according to the setting of the voltage data in the ROM 5c. By setting the voltage data (which are stored in the temperature addresses of the ROM 5c corresponding to each temperature) so as to compensate for the change of the gain of the APD1 due to the change of the temperature, the temperature-variation of the gain of the APD1 can be compensated by the bias voltage Vj and eliminated.

As described above, by the APD biasing circuit according to the first embodiment of the present invention, the temperature-effect on the transfer function of the APD 1 is digitally compensated by the proper bias voltage control by the digital temperature compensation circuit 5 depending on the detected temperature using the voltage data which have been preliminarily set and stored in the ROM 5c, thereby the temperature-variation of the gain of the APD1 is compensated and eliminated, and thereby the S/N of the photo detection signal outputted by the APD 1 can be maintained constant in a wide temperature range.

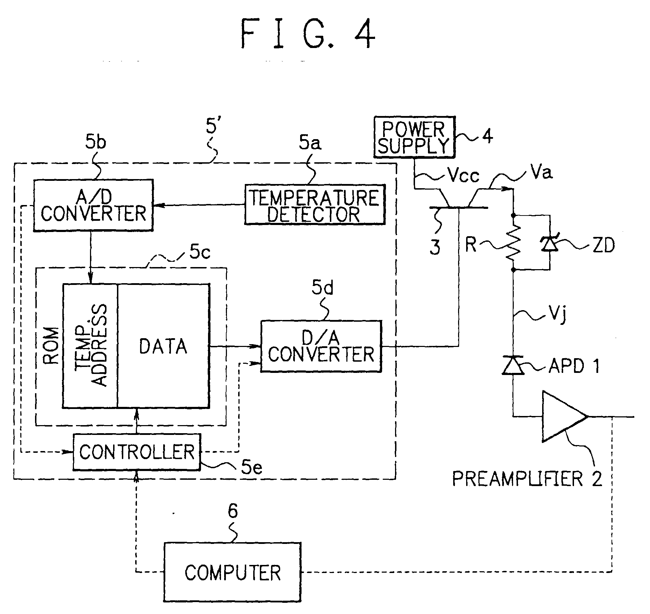

Fig.4 is a circuit diagram showing an APD biasing circuit in accordance with a second embodiment of the present invention. Referring to Fig.4, the APD biasing circuit of the second embodiment further comprises a Zenner diode ZD which is connected in parallel to the resistor R. Further, a controller 5e for executing voltage data setting/writing to the ROM 5c is added to the digital temperature compensation circuit 5 of the first embodiment and thereby a digital temperature compensation circuit 5' is formed.

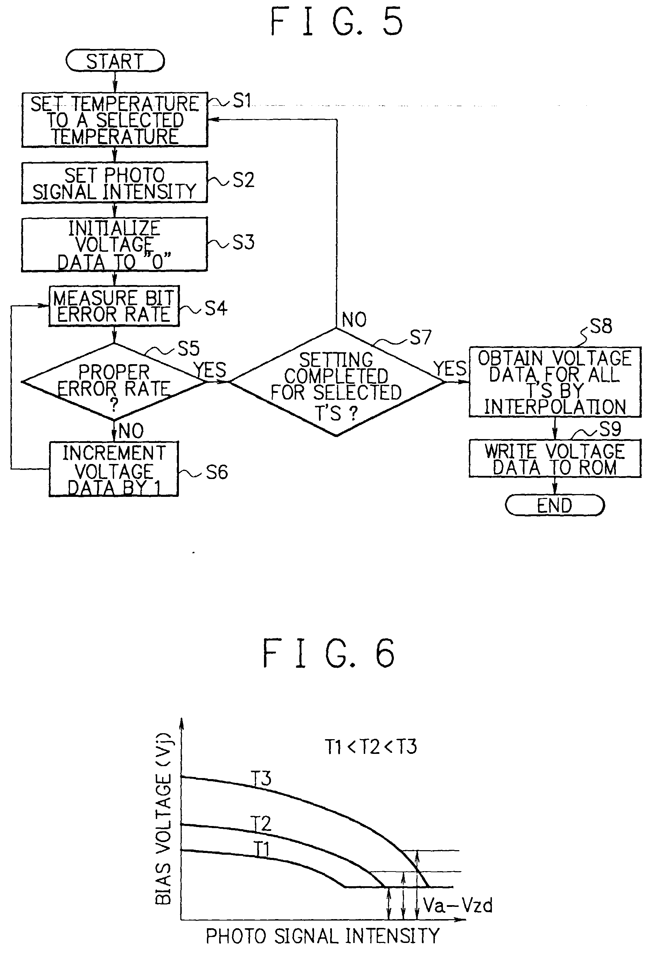

Fig.5 is a flow chart showing an example of a procedure for setting and writing the voltage data corresponding to each temperature in the ROM 5c.

First, the temperature around the APD biasing circuit and the APD 1 is set to a particular selected temperature in a prescribed temperature range (step S1), and the intensity of the inputted photo signal is set to a particular intensity (step S2). Subsequently, the controller 5e initializes its voltage data (corresponding to the "selected temperature" of the step S1) into "0" (step S3). Thereafter, the bit error rate of the photo detection signal (which is outputted by the APD 1 depending on the intensity of the inputted photo signal) is measured by an external device such as a computer 6 by use of the output of the preamplifier 2, for example (step S4). The bit error rate calculated by the external device such as the computer 6 is supplied to the controller 5e.

If the bit error rate is larger than a prescribed error rate ("NO" in step S5), the controller 5e increments the voltage data corresponding to the "selected temperature" of the step S1 (which is being stored in the controller 5e and being supplied to the D/A converter 5d) by 1 in order to increase the emitter voltage Va (step S6). Thereafter, the process is returned to the step S4 and the measurement of the bit error rate is executed again.

If the bit error rate has become lower than or equal to the prescribed error rate ("YES" in step S5), the controller 5e proceeds to step S7 and judges whether or not the setting of the voltage data has been completed with respect to all the selected temperatures in the prescribed temperature range. If the setting has not been completed ("NO" in step S7), the process is returned to the step S1 and the temperature around the APD biasing circuit and the APD 1 is set to the next selected temperature. Thereafter, the process described above is repeated for the next selected temperature.

If the setting of the voltage data has been completed with respect to all the selected temperatures in the prescribed temperature range ("YES" in step S7), the controller 5e calculates voltage data with respect to all the temperatures in the prescribed temperature range by means of interpolation (step S8). By use of the interpolation, the time necessary for the voltage data setting can be shortened. Thereafter the controller 5e writes the calculated voltage data with respect to the temperatures in the prescribed temperature range into corresponding temperature addresses of the ROM 5c (step S9).

By the procedure described above, optimized voltage data corresponding to each temperature in the prescribed temperature range (by which the bit error rate of the photo detection signal outputted by the APD 1 is made lower than the prescribed error rate) are written in the ROM 5c.

After the above voltage data setting/writing process for the ROM 5c has been completed, the bias voltage Vj of the APD 1 is controlled as follows. The temperature around the APD 1 is detected by the temperature detector 5a, and voltage data which has been stored at a temperature address corresponding to the detected temperature is read out from the ROM 5c. The voltage data read out from the ROM 5c is converted by the D/A converter 5d into an analog voltage, and the voltage is supplied to the base of the transistor 3, thereby the emitter voltage Va is appropriately controlled depending on the detected temperature. Consequently, the bias voltage Vj of the APD 1 is controlled adequately so that the bit error rate of the photo detection signal outputted by the APD 1 will become lower than the prescribed error rate in the prescribed temperature range.

Fig.6 is a graph showing a result of a simulation with regard to the bias voltage Vj according to the second embodiment of the present invention, which has been conducted by the present inventors. The bias voltage Vj corresponding to various photo signal intensity is corrected depending on the temperature so as to compensate and eliminate the temperature-variation of the gain of the APD 1. Concretely, as the temperature becomes higher, the voltage data which is read out from the ROM 5c becomes higher, thereby the base voltage and the emitter voltage Va of the transistor 3 become higher, and thereby the bias voltage Vj of the APD 1 is made higher.

When the intensity of the photo signal supplied to the APD 1 increases, the voltage drop of the resistor R increases, and thereby the bias voltage Vj is decreased. After the decreasing bias voltage Vj reached a critical voltage Va - Vzd (Va: emitter voltage, Vzd: clamp voltage of the Zener diode ZD) due to the increase of the photo signal intensity, the bias voltage Vj becomes constant, thereby the minimum bias voltage of the APD 1 is ensured, and thereby malfunction of the APD 1 due to incidence of high level photo signals is prevented.

As described above, by the APD biasing circuit according to the second embodiment of the present invention, the temperature-variation of the gain of the APD1 is compensated and eliminated by the bias voltage control of the digital temperature compensation circuit 5' and thereby the S/N of the photo detection signal outputted by the APD 1 can be maintained so that the bit error rate of the photo detection signal will be lower than the prescribed error rate, similarly to the first embodiment. Further, by the voltage data setting/writing operation of the controller 5e, proper voltage data with respect to all the temperatures in the prescribed temperature range are automatically written in the ROM 5c as a result of actual measurement of the photo detection signal outputted by the APD 1, therefore, the voltage data setting/writing process can be executed correctly with respect to the particular APD 1. Furthermore, malfunction of the APD 1 due to incidence of high level photo signals is prevented by use of the Zenner diode ZD for ensuring the minimum bias voltage of the APD 1.

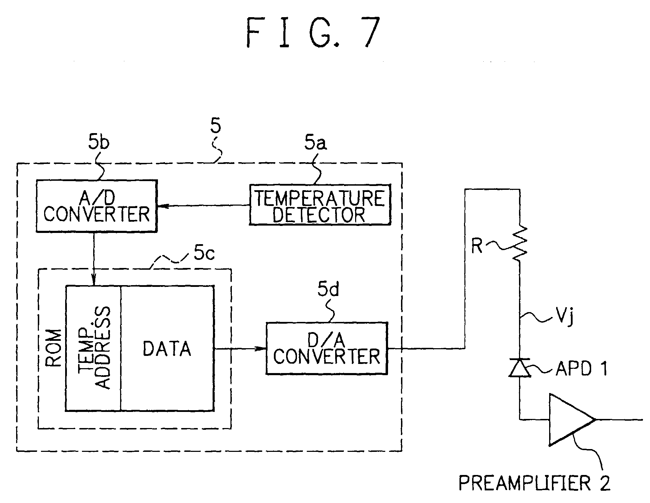

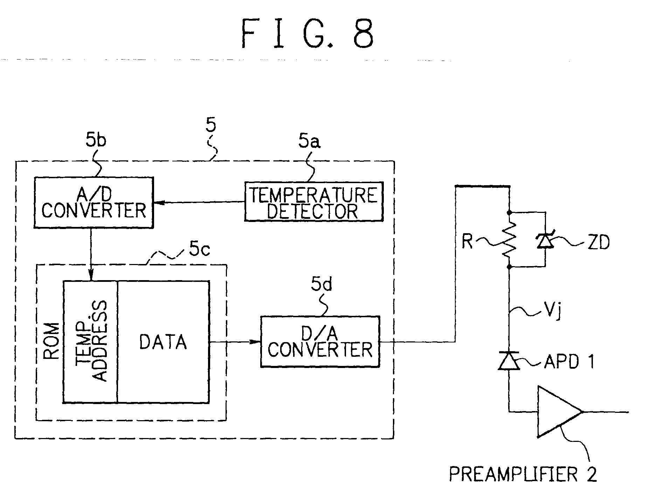

Incidentally, while the APD biasing circuits of the above embodiments included the power supply 4 and the transistor 3, they can be omitted as shown in Figs.7 and 8 if the D/A converter 5d can supply the resistor R with sufficient and proper voltage.

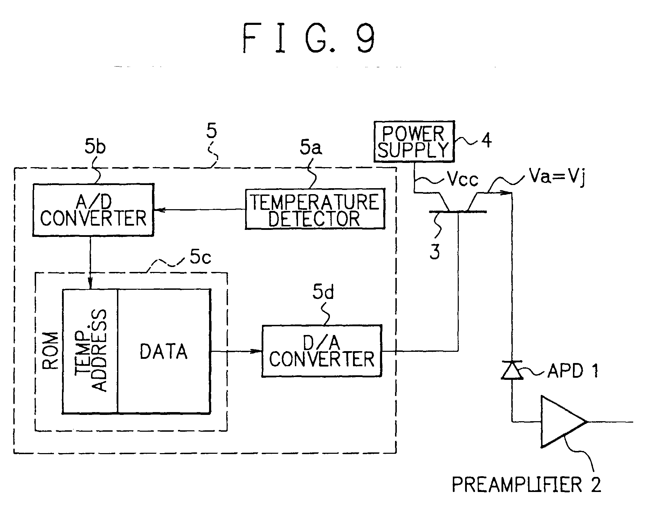

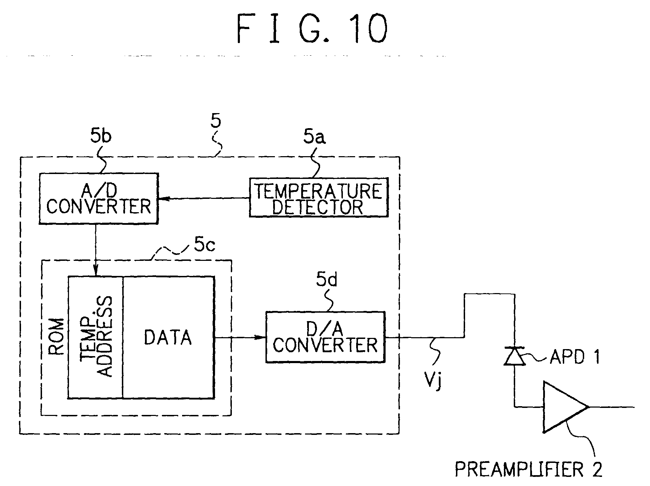

In addition, the above description of the preferred embodiments has been given with regard to a case where the resistor R is connected to the APD 1 in series for enlarging the input level range of the APD 1 by lowering the bias voltage Vj as the photo signal intensity increases. However, of course, the present invention can also be applied to an APD to which the resistor R is not connected in series, as shown in Figs.9 and 10.

As set forth hereinabove, in the APD biasing circuit according to the present invention, the temperature-variation of the gain of the APD 1 is automatically compensated and eliminated in a wide temperature range by the proper control of the bias voltage Vj depending on the detected temperature based on the voltage data which are preliminarily stored in the ROM 5c, thereby the S/N of the photo detection signal outputted by the APD 1 can be maintained at an optimal value in a wide temperature range without the need of manual control of the bias voltage Vj of the APD 1. Therefore, devices and parts (which are provided with APDs) which are capable of operating stably in a wide temperature range without manual control of the bias voltage Vj of the APD can be manufactured by use of the APD biasing circuit according to the present invention.

While the present invention has been described with reference to the particular illustrative embodiments, it is not to be restricted by those embodiments but only by the appended claims. It is to be appreciated that those skilled in the art can change or modify the embodiments without departing from the scope and spirit of the present invention.

## Claims

1. An APD biasing circuit for applying a bias voltage (Vj) to an APD (Avalanche PhotoDiode) (1) which outputs a photo detection signal corresponding to the intensity of a photo signal supplied thereto, comprising:
a temperature detector means (5a) for detecting the temperature around the APD (1);
a storage means (5c) which preliminarily stores voltage data corresponding to a plurality of temperatures in a prescribed temperature range which have been set so as to properly control the bias voltage (Vj) of the APD (1) and thereby compensate for the temperature-variation of the gain of the APD (1), and outputs voltage data corresponding to the temperature which has been detected by the temperature detector means (5a);
a D/A converter means (5d) for converting the voltage data which has been outputted by the storage means (5c) into an analog voltage; and
a voltage control means (3, 4) for controlling the bias voltage (Vj) of the APD (1) based on the analog voltage.

2. An APD biasing circuit as claimed in claim 1, further comprising an A/D converter (5b) for converting an analog temperature detection signal outputted by the temperature detector means (5a) into a digital signal to be supplied to the storage means (5c).

3. A circuit as claimed in claim 1 or 2, wherein the voltage control means (3, 4, R) includes:
a resistor (R) which is connected in series with the APD (1) so as to reduce the bias voltage (Vj) by its voltage drop as the photo signal intensity increases;
a power supply (4) for outputting a constant power supply voltage (Vcc); and
a transistor (3) whose collector is supplied with the power supply voltage (Vcc) from the power supply (4) and whose base is supplied with the analog voltage from the D/A converter means (5d) and whose emitter is connected to the APD (1) via the resistor (R).

4. An APD biasing circuit as claimed in claim 3, wherein the voltage control means (3, 4, R, ZD) further includes a Zener diode (ZD) which is connected in parallel with the resistor (R) so as to ensure the minimum bias voltage of the APD (1).

5. A circuit as claimed in claim 1 or 2, wherein the voltage control means (3, 4) includes:
a power supply (4) for outputting a constant power supply voltage (Vcc); and
a transistor (3) whose collector is supplied with the power supply voltage (Vcc) from the power supply (4) and whose base is supplied with the analog voltage from the D/A converter means (5d) and whose emitter is connected to the APD (1).

6. A circuit as claimed in claim 1, 2, 3, 4 or 5, wherein the D/A converter means (5d) and the voltage control means (R) are implemented by a D/A converter (5d) whose analog output voltage is supplied to the APD (1) via a resistor (R) which reduces the bias voltage (Vj) by its voltage drop as the photo signal intensity increases.

7. An APD biasing circuit as claimed in claim 6, wherein the voltage control means (R, ZD) further includes a Zener diode (ZD) which is connected in parallel with the resistor (R) so as to ensure the minimum bias voltage of the APD (1).

8. A circuit as claimed in any one of claims 1 to 7, wherein the D/A converter means (5d) and the voltage control means are implemented by a D/A converter (5d) whose analog output voltage is supplied to the APD (1).

9. A circuit as claimed in any one of claims 1 to 8, wherein the storage means (5c) is implemented by an EPROM (Erasable Programmable Read Only Memory).

10. A circuit as claimed in any one of claims 1 to 9, further comprising a voltage data setting/writing controller means (5e) for executing voltage data setting/writing process for the storage means (5c), in which:
the voltage data writing controller means (5e) in a voltage data setting process outputs voltage data to the D/A converter means (5d) in place of the storage means (5c) gradually changing the voltage data so that suitable voltage data capable of making the bit error rate of the photo detection signal lower than a prescribed error rate will be found for temperatures in a prescribed temperature range, and
the voltage data writing controller means (5e) in a voltage data writing process writes the suitable voltage data for the temperatures in the prescribed temperature range which have been found in the voltage data setting process into the storage means (5c).

11. An APD biasing method for applying a bias voltage (Vj) to an APD (Avalanche PhotoDiode) (1) which outputs a photo detection signal corresponding to the intensity of a photo signal supplied thereto, comprising the steps of:
a temperature detection step in which the temperature around the APD (1) is detected by a temperature detector means (5a);
a voltage data readout step in which voltage data corresponding to the temperature which has been detected in the temperature detection step is read out from a corresponding temperature address of a storage means (5c) which preliminarily stores voltage data corresponding to a plurality of temperatures in a prescribed temperature range which have been set so as to properly control the bias voltage (Vj) of the APD (1) and thereby compensate for the temperature-variation of the gain of the APD (1);
a D/A conversion step in which the voltage data which has been read out in the voltage data readout step is converted by a D/A converter means (5d) into an analog voltage; and
a voltage control step in which the bias voltage (Vj) of the APD (1) is controlled based on the analog voltage which has been obtained in the D/A conversion step.

12. An APD biasing method as claimed in claim 11, further comprising an A/D conversion step in which an analog temperature detection signal outputted by the temperature detector means (5a) is converted into a digital signal to be used by the storage means (5c) in the voltage data readout step.

13. A method as claimed in claim 11 or 12, wherein the voltage control step is executed by:
a resistor (R) which is connected in series with the APD (1) so as to reduce the bias voltage (Vj) by its voltage drop as the photo signal intensity increases;
a power supply (4) for outputting a constant power supply voltage (Vcc); and
a transistor (3) whose collector is supplied with the power supply voltage (Vcc) from the power supply (4) and whose base is supplied with the analog voltage from the D/A converter means (5d) and whose emitter is connected to the APD (1) via the resistor (R).

14. An APD biasing method as claimed in claim 13, wherein the voltage control step includes a clamping step in which a Zener diode (ZD) which is connected in parallel with the resistor (R) clamps the voltage drop of the resistor (R) when the voltage drop became as large as its clamp voltage (Vzd), and thereby ensures the minimum bias voltage of the APD (1).

15. A method as claimed in claim 11 or 12, wherein the voltage control step is executed by:
a power supply (4) for outputting a constant power supply voltage (Vcc); and
a transistor (3) whose collector is supplied with the power supply voltage (Vcc) from the power supply (4) and whose base is supplied with the analog voltage from the D/A converter means (5d) and whose emitter is connected to the APD (1).

16. A method as claimed in claim 11, 12, 13, 14 or 15, wherein the D/A conversion step and the voltage control step are executed by a D/A converter (5d) whose analog output voltage is supplied to the APD (1) via a resistor (R) which reduces the bias voltage (Vj) by its voltage drop as the photo signal intensity increases.

17. An APD biasing method as claimed in claim 16, wherein the voltage control step includes a clamping step in which a Zenner diode (ZD) which is connected in parallel with the resistor (R) clamps the voltage drop of the resistor (R) when the voltage drop became as large as its clamp voltage (Vzd), and thereby ensures the minimum bias voltage of the APD (1).

18. A method as claimed in any one of claims 11 to 17, wherein the D/A conversion step and the voltage control step are executed by a D/A converter (5d) whose analog output voltage is supplied to the APD (1).

19. A computer-readable record medium storing a program for instructing a computer or a DSP (Digital Signal Processor) to execute processes for controlling a bias voltage (Vj) which is applied to an APD (Avalanche PhotoDiode) (1) which outputs a photo detection signal corresponding to the intensity of a photo signal supplied thereto, wherein the processes include:
a temperature detection signal reception step in which a temperature detection signal representing the temperature around the APD (1) which has been detected by a temperature detector means (5a) is received;
a voltage data readout step in which voltage data corresponding to the temperature represented by the temperature detection signal is read out from a corresponding temperature address of a storage means (5c) which preliminarily stores voltage data corresponding to a plurality of temperatures in a prescribed temperature range which have been set so as to properly control the bias voltage (Vj) of the APD (1) and thereby compensate for the temperature-variation of the gain of the APD (1); and
a voltage data output step in which the voltage data which has been read out from the storage means (5c) in the voltage data readout step is outputted so as to be converted into an analog voltage and thereafter used for controlling the bias voltage (Vj) of the APD (1).

20. A computer-readable record medium as claimed in claim 19, wherein the processes further include an A/D conversion step in which an analog temperature detection signal outputted by the temperature detector means (5a) is converted into a digital signal to be used by the storage means (5c) in the voltage data readout step.
